# EUROPEAN PATENT APPLICATION

(11) **EP 4 624 937 A1**
(43) Date of publication of application: **01.10.2025**
(21) Application number: 23894619.8
(22) Date of filing: 22.11.2023
(51) Int. Cl.: G01R 1/073, G01R 1/067

(54) **INSPECTION TOOL**

(30) Priority: 25.11.2022 JP 2022187907
(71) Applicant: Yokowo Co., Ltd, Tokyo 101-0041 (JP)
(72) Inventor: MIURA, Chikara, Tokyo 114-8515 (JP); SUZUKI, Hisashi, Tokyo 114-8515 (JP)
(74) Representative: Gunzelmann, Rainer
(86) International application number: PCT/JP2023/041934
(87) International publication number: WO 2024/111615

(57) **Abstract**

Provided is an inspection tool that does not readily break. An inspection tool 1 comprises: a substrate that can be electrically connected to a connector 100 being inspected; a movable member that can be moved; a stretchable member that can be stretched; a stretchable member holding unit that holds the stretchable member; and an elastic member that urges the movable member and the stretchable member holding unit away from each other. When the movable member is brought closer to the stretchable member holding unit so that the elastic member contracts by a predetermined amount or more, the movable member pushes the stretchable member and the stretchable member pushes the substrate, resulting in a state in which the substrate is electrically connected to the connector 100 being inspected.

## Description

### TECHNICAL FIELD

The present invention relates to an inspection jig.

### BACKGROUND ART

In the related art, as disclosed in Patent Literature 1, an inspection jig using a probe has been proposed.

### CITATION LIST

### PATENT LITERATURE

Patent Literature 1: JP6380549B

### SUMMARY OF INVENTION

### TECHNICAL PROBLEM

However, the probe is configured to directly contact an inspection target, and the inspection jig is likely to be damaged.

Therefore, an object of the present invention is to provide an inspection jig that is less likely to be damaged. Other objects of the present invention will become apparent based on the present description.

### SOLUTION TO PROBLEM

According to an aspect of the present invention, there is provided an inspection jig including: a substrate that is electrically connectable to an inspection target connector; a movable member that is movable; an extendable member that is extendable; an extendable member holding portion that holds the extendable member; and an elastic member that biases the movable member and the extendable member holding portion to be separated from each other. In the inspection jig, when the movable member is brought close to the extendable member holding portion such that the elastic member contracts by a predetermined amount or more, the movable member presses the extendable member, the extendable member presses the substrate, and the substrate is electrically connected to the inspection target connector.

According to the above aspect of the present invention, it is possible to provide an inspection jig that is less likely to be damaged.

### BRIEF DESCRIPTION OF DRAWINGS

[FIG. 1] FIG. 1 is an exploded perspective view of an inspection jig of the present embodiment as viewed from below.
[FIG. 2] FIG. 2 is an exploded perspective view of the inspection jig as viewed from above.
[FIG. 3] FIG. 3 is a perspective view of the inspection jig and an inspection target connector as viewed from above.
[FIG. 4] FIG. 4 is a perspective view of the inspection jig and an inspection target connector as viewed from below.
[FIG. 5] FIG. 5 is an exploded perspective view of a front-side substrate assembly.
[FIG. 6] FIG. 6 is a perspective view of an assembly of a front-side flexible substrate and a front-side connector, a front-side probe holding portion, a front-side connector base, and a front-side probe group.
[FIG. 7] FIG. 7 is a perspective view of a region where tongue pieces of the front-side flexible substrate are present as viewed from a front side and a lower side.
[FIG. 8] FIG. 8 is an exploded perspective view of a rear-side substrate assembly.
[FIG. 9] FIG. 9 is a yz cross-sectional configuration view of the inspection jig and the inspection target connector in a first state.
[FIG. 10] FIG. 10 is an xz cross-sectional configuration view in which the region where the tongue pieces of the front-side flexible substrate are present in the first state is enlarged.
[FIG. 11] FIG. 11 is a yz cross-sectional configuration view of the inspection jig and the inspection target connector in a second state.
[FIG. 12] FIG. 12 is a yz cross-sectional configuration view of the inspection jig and the inspection target connector in a third state.
[FIG. 13] FIG. 13 is a yz cross-sectional configuration view of the inspection jig and the inspection target connector in a fourth state.
[FIG. 14] FIG. 14 is an xz cross-sectional configuration view in which the region where the tongue pieces of the front-side flexible substrate are present in the fourth state is enlarged.

### DESCRIPTION OF EMBODIMENTS

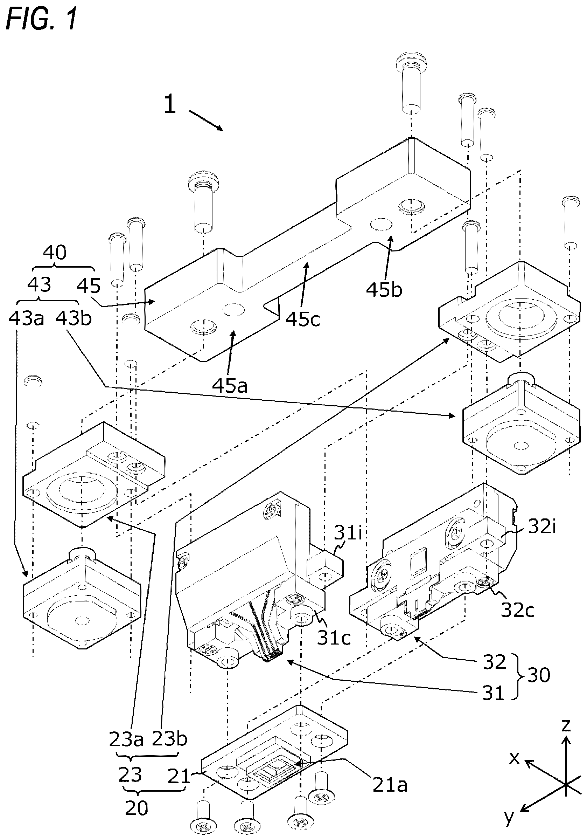

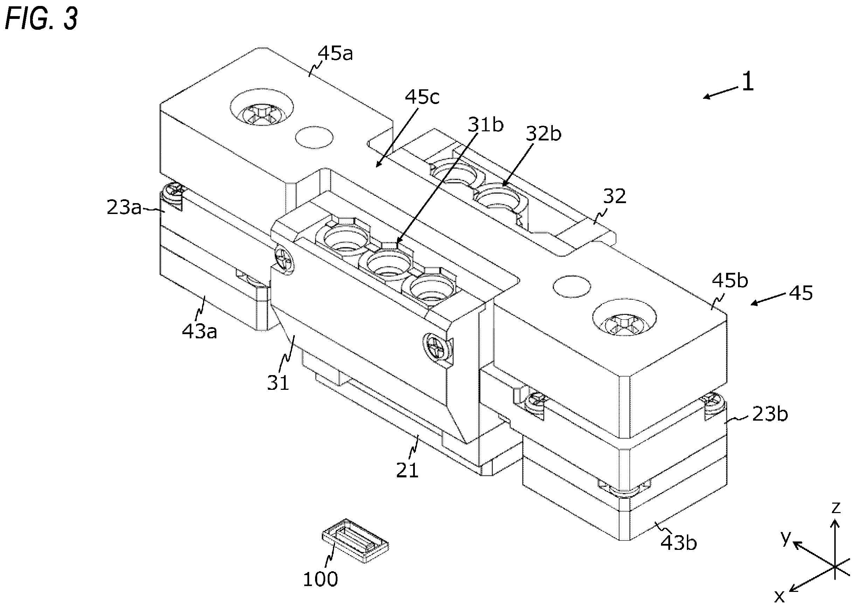

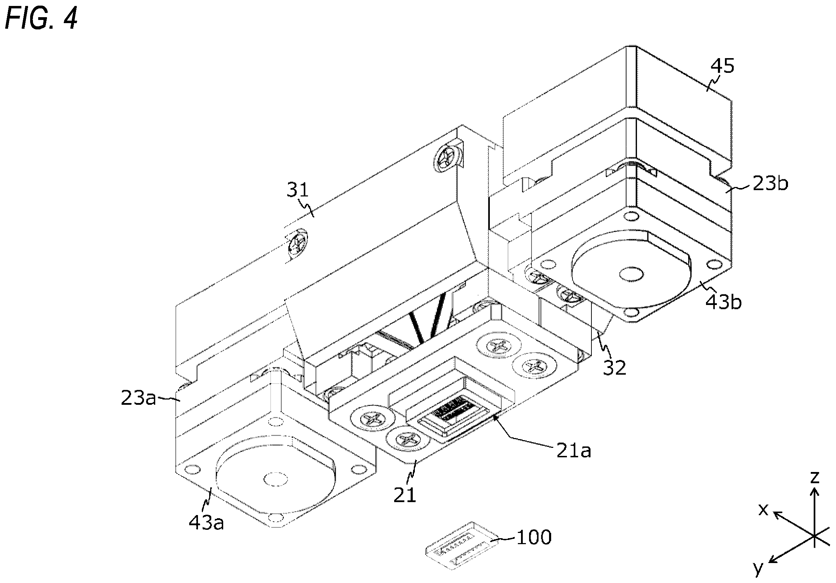

Hereinafter, the present embodiment will be described with reference to FIGS. 1 to 8. Embodiments are not limited to the following embodiment. Contents described in one embodiment are similarly applied to other embodiments in principle. The embodiments and modifications can be combined as appropriate.

### (Inspection Jig 1)

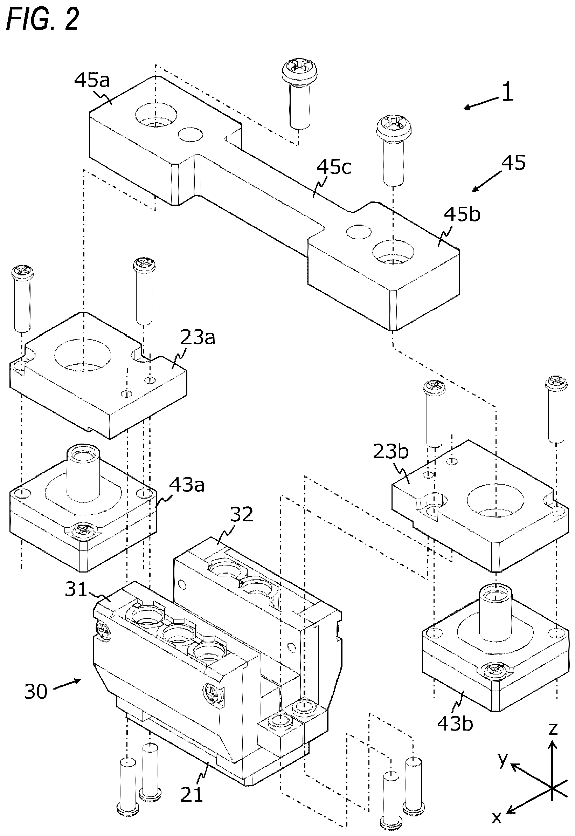

As illustrated in FIGS. 1 to 8, an inspection jig 1 according to the present embodiment includes a substrate holding portion 20, a substrate portion 30, and a horizontal position adjusting portion 40. The inspection jig 1 is brought into contact with an inspection target connector (B to B connector, board to board connector) 100 to be inspected via a connector contact portion 21a at a lower end of a lower-side holding portion 21 of the substrate holding portion 20, and is electrically connected to a front-side flexible substrate 31a and a rear-side flexible substrate 32a inside. In FIGS. 1 and 2, the inspection target connector 100 is not illustrated.

In order to describe directions, a horizontal direction (front-rear direction) in which two substrate assemblies (front-side substrate assembly 31 and rear-side substrate assembly 32) are arranged is referred to as an x direction, a direction (left-right direction) that is perpendicular to the x direction and has two support portions 43 (right support member 43a and left support member 43b) arranged therein is referred to as a y direction, and a direction (up-down direction) perpendicular to the x direction and the y direction is referred to as a z direction (first direction). In FIG. 1, directions indicated by arrows of xyz axes are defined as a forward direction, a rightward direction, and an upward direction, respectively. Specifically, a direction from the rear-side substrate assembly 32 toward the front-side substrate assembly 31 is defined as the forward direction. In addition, of the two support portions 43, a direction from the left support member 43b positioned at the upper right in Fig. 1 to the right support member 43a positioned at the lower left in Fig. 1 is defined as the rightward direction. Further, a direction from the lower-side holding portion 21 toward the horizontal position adjusting portion 40 is defined as the upward direction.

### (Substrate Holding Portion 20)

The substrate holding portion 20 includes the lower-side holding portion (workpiece guide) 21 and an upper-side holding portion (connection plate) 23. The lower-side holding portion 21 is provided on a lower side of the substrate portion 30 in the z direction. The upper-side holding portion 23 is provided on an upper side of the substrate portion 30 in the z direction. The lower-side holding portion 21 and the upper-side holding portion 23 sandwich the substrate portion 30 in the z direction.

The lower-side holding portion 21 is a member that is brought into contact with a housing of the inspection target connector 100. The housing of the inspection target connector 100 is a member that holds an electrode that is brought into contact with the front-side flexible substrate 31a or the rear-side flexible substrate 32a. The lower-side holding portion 21 has a hole penetrating in the z direction. A lower end of the substrate portion 30 is inserted into the hole of the lower-side holding portion 21 from an upper side in the z direction. A convex portion (connector contact portion 21a) is formed on a lower side of the lower-side holding portion 21 in the z direction. An upper end of the inspection target connector 100 is inserted into the connector contact portion 21a from the lower side in the z direction. That is, the inspection target connector 100 is attached to the connector contact portion 21a in a detachable state.

A front-side probe holding portion 31c of the front-side substrate assembly 31 and a rear-side probe holding portion 32c of the rear-side substrate assembly 32 are attached to the upper side of the lower-side holding portion 21 in the z direction. Attachment of the front-side probe holding portion 31c to the lower-side holding portion 21 is performed by screwing from the lower side in the z direction. Attachment of the rear-side probe holding portion 32c to the lower-side holding portion 21 is performed by screwing from the lower side in the z direction. Therefore, the front-side probe holding portion 31c and the rear-side probe holding portion 32c are attached to the lower-side holding portion 21 in a state where a distance in the z direction from a region of the lower-side holding portion 21 (connector contact portion 21a) that is in contact with the housing of the inspection target connector 100 does not vary.

The upper-side holding portion 23 includes an upper right holding member 23a and an upper left holding member 23b. A front-side push block 31i of the front-side substrate assembly 31 and a rear-side push block 32i of the rear-side substrate assembly 32 are attached to a lower side of the upper-side holding portion 23 in the z direction. Attachment of the front-side push block 31i to the upper-side holding portion 23 is performed by screwing from the upper side in the z direction. Attachment of the rear-side push block 32i to the upper-side holding portion 23 is performed by screwing from the upper side in the z direction.

### (Substrate Portion 30)

The substrate portion 30 includes the front-side substrate assembly 31 and the rear-side substrate assembly 32. The front-side substrate assembly 31 is disposed on a front side in the x direction, and the rear-side substrate assembly 32 is disposed on a rear side in the x direction.

### (Front-side Substrate Assembly 31)

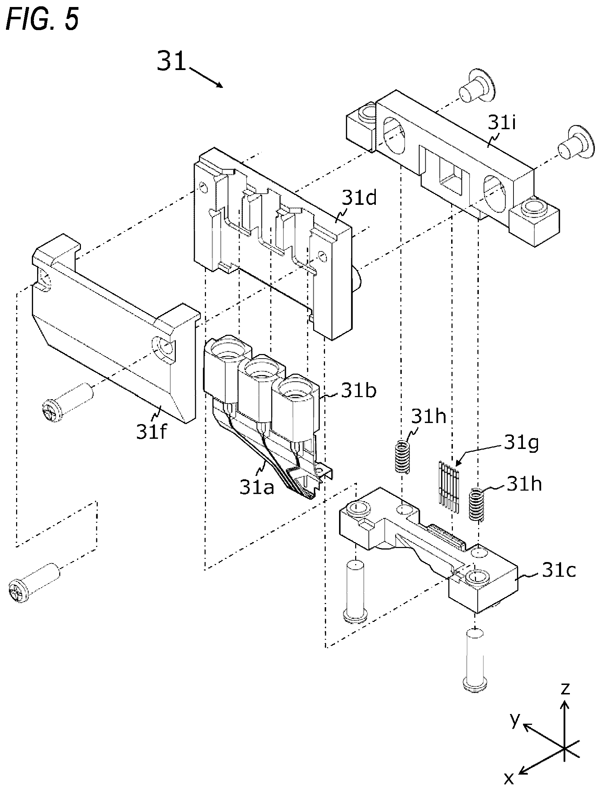

As illustrated in FIG. 5, the front-side substrate assembly 31 includes the front-side flexible substrate (flexible substrate) 31a, a front-side connector 31b, the front-side probe holding portion (extendable member holding portion) 31c, a front-side connector base 31d, a front-side connector cover 31f, a front-side probe group 31g, front-side springs 31h, and the front-side push block (movable member) 31i.

### (Front-side Flexible Substrate 31a)

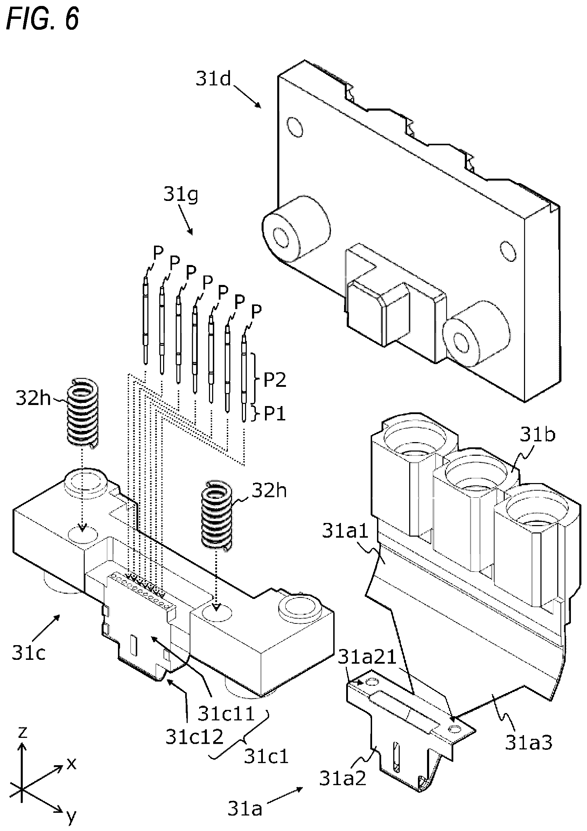

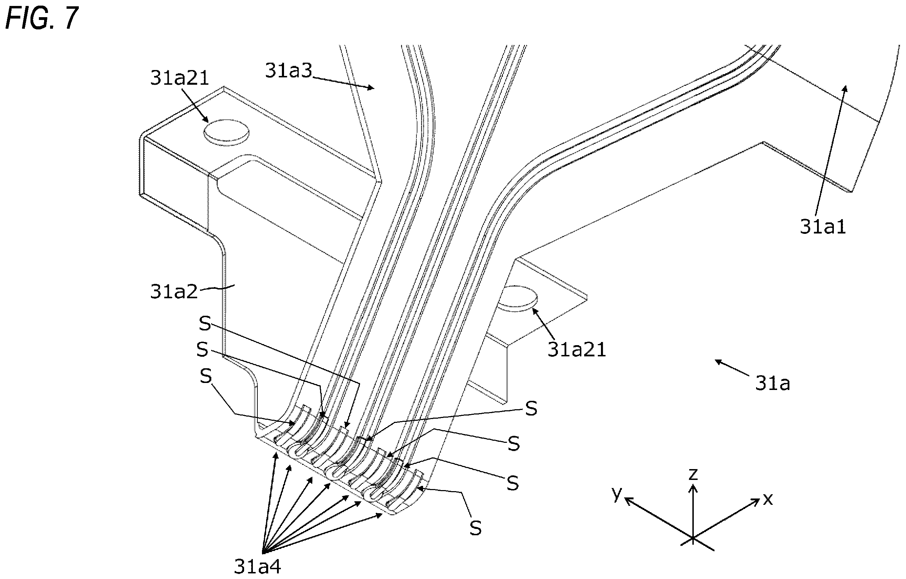

As illustrated in FIGS. 6 and 7, the front-side flexible substrate 31a includes a connector connection end (one end portion) 31a1, a holding portion connection end (the other end portion) 31a2, and a pattern portion 31a3.

The connector connection end 31a1 is an end portion of the front-side flexible substrate 31a on the front side in the x direction and on the upper side in the z direction. The front-side connector 31b is attached to the connector connection end 31a1 by soldering or the like. The holding portion connection end 31a2 is an end portion of the front-side flexible substrate 31a on the rear side in the x direction and on the upper side in the z direction, and is attached to the front-side probe holding portion 31c. For example, through holes 31a21 provided in the holding portion connection end 31a2 are fitted into bosses (not illustrated) provided on an upper side of a probe receptacle 31c1 of the front-side probe holding portion 31c in the z direction. However, attachment of the holding portion connection end 31a2 and the front-side probe holding portion 31c is not limited to the fitting of the through holes 31a21 into the bosses.

The pattern portion 31a3 is a region between the connector connection end 31a1 and the holding portion connection end 31a2. A pattern of a signal line extending from the connector connection end 31a1 and a ground line is formed on a surface on a lower side (surface side) of the pattern portion 31a3 in the z direction. The pattern portion 31a3 is bent so as to have a substantially V shape when viewed from the y direction. On a surface on the lower side of the pattern portion 31a3 in the z direction, end portions of the signal line and the ground line are provided at a lower end portion that is in a state of being bent so as to have a substantially V shape. The end portions of the signal line and the ground line are used as substrate-side electrodes that are electrically connected to the electrodes of the inspection target connector 100. In addition, slits S are provided around the end portions of the signal line and the ground line (region including a portion of the pattern portion 31a3 electrically connected to the inspection target connector 100). Tongue pieces 31a4 having a substantially U shape are formed by the slits S. The slit S is a notch (cut) of which both ends are closed ends, but may have an open end at one end and a closed end at the other end. The pattern provided on the surface on the lower side (surface side) of the pattern portion 31a3 in the z direction is not limited to the signal line and the ground line.

In order to increase an amount of displacement to the lower side in the z direction by probes P of the front-side probe group 31g to be described later, it is desirable to increase a length in a longitudinal direction of the slits S forming the tongue pieces 31a4. On the other hand, in order to prevent characteristics of the signal line in a high frequency region from being deteriorated, it is desirable to shorten the length in the longitudinal direction of the slits S forming the tongue pieces 31a4. Therefore, the length in the longitudinal direction of the slits S forming the tongue pieces 31a4 is determined in consideration of the amount of displacement to the lower side in the z direction of the tongue pieces 31a4 and the characteristics of the signal line in the high frequency region. In one tongue piece 31a4, only one signal line, one ground line, or one power line may be provided, or at least one of the signal line, the ground line, and the power line may be provided in plural. The tongue piece 31a4 may be provided with a line of a type other than the signal line, the ground line, and the power line.

The tongue piece 31a4 formed by the slit S is not limited to the substantially U shape. As long as the pattern portion 31a3 can be displaced from the upper side in the z direction to the lower side in the z direction by the probes P of the front-side probe group 31g in a state where the pattern portion 31a3 does not extend, the tongue piece 31a4 may have other shapes such as a substantially V shape, a substantially C shape, a substantially L shape, and a substantially groove shape.

In drawings other than FIGS. 1, 4, 5, and 7, illustrations of the signal line and the ground line of the pattern portion 31a3, the slits S, and the tongue pieces 31a4 are omitted.

### (Front-side Connector 31b)

The front-side connector 31b is attached to the connector connection end 31al of the front-side flexible substrate 31a. The front-side connector 31b is used for electrically connecting the front-side flexible substrate 31a to an inspection device (not illustrated).

### (Front-side Probe Holding Portion 31c)

The front-side probe holding portion 31c holds the front-side connector base 31d on the front side in the x direction. The front-side probe holding portion 31c holds the holding portion connection end 31a2 of the front-side flexible substrate 31a on the rear side in the x direction.

### (Probe Receptacle 31c1)

The probe receptacle 31c1 that holds the front-side probe group 31g is provided on the rear side in the x direction and on the lower side in the z direction of the front-side probe holding portion 31c.

The probe receptacle 31c1 is configured by holes extending in the z direction. However, the probe receptacle 31c1 may be configured by grooves extending in the z direction, or may be configured by grooves and holes. Widths of an upper portion (31c11) of the hole of the probe receptacle 31c1 in the x direction and the y direction are larger than an outer diameter of a spring accommodation portion (barrel) P2 of the probes P constituting the front-side probe group 31g. Widths of a lower portion (31c12) of the hole of the probe receptacle 31c1 in the x direction and the y direction are larger than an outer diameter of a distal end portion P1 of the probes P constituting the front-side probe group 31g and smaller than the outer diameter of the spring accommodation portion P2. An upper end and a lower end of the groove and/or the hole of the probe receptacle 31c1 are opened. An upper end portion of the probe P protrudes upward through the upper portion 31c11 of the hole of the probe receptacle 31c1 and is brought into contact with the front-side push block 31i. A lower end portion of the probe P protrudes downward through the lower portion 31c12 of the hole of the probe receptacle 31c1 and is brought into contact with the tongue piece 31a4.

### (Attachment of Front-side Flexible Substrate 31a to Front-side Probe Holding Portion 31c)

The front-side flexible substrate 31a is attached to the front-side probe holding portion 31c so as to satisfy the following two conditions.

First condition: a lower side of the front-side probe holding portion 31c in the z direction faces a surface on an upper side of the pattern portion 31a3 of the front-side flexible substrate 31a in the z direction.

Second condition: the end portions of the signal line and the ground line of the pattern portion 31a3 of the front-side flexible substrate 31a are positioned on a lower side of the probe receptacle 31c1 of the front-side probe holding portion 31c in the z direction.

### (Front-side Connector Base 31d)

The front-side connector base 31d holds the front-side connector 31b on the front side in the x direction (see FIG. 5). The front-side connector base 31d is positioned on the upper side in the z direction with respect to the front-side probe holding portion 31c, and is attached to the front-side probe holding portion 31c.

An assembly of the front-side flexible substrate 31a and the front-side connector 31b is attached to an assembly of the front-side probe holding portion 31c and the front-side connector base 31d so as to sandwich the front-side probe holding portion 31c and the front-side connector base 31d in the x direction and to wrap a lower end of the front-side probe holding portion 31c. Attachment of the front-side probe holding portion 31c to the front-side connector base 31d is performed by screwing from the lower side in the z direction.

### (Front-side Connector Cover 31f)

The front-side connector cover 31f covers a part of the pattern portion 31a3 of the front-side flexible substrate 31a and a front side of the front-side connector 31b in the x direction. Attachment of the front-side connector cover 31f to the front-side connector base 31d is performed by screwing from the front side in the x direction. The front-side connector cover 31f and the front-side connector base 31d sandwich the front-side connector 31b in the x direction.

### (Front-side Probe Group 31g)

The front-side probe group 31g includes a plurality of probes (extendable members) P that extend and contract in the z direction (see FIG. 6). The plurality of probes P are arranged in the y direction. Each of the probes P constituting the front-side probe group 31g has the distal end portion P1 on the lower side in the z direction, and has the spring accommodation portion P2 on the upper side in the z direction with respect to the distal end portion P1. A spring (not illustrated) is accommodated in the spring accommodation portion P2. The distal end portion P1 is biased by the spring in the spring accommodation portion P2 in a direction in which an entire length of the distal end portion P1 extends.

When each of the probes P constituting the front-side probe group 31g is placed on the probe receptacle 31c1 of the front-side probe holding portion 31c in a state where the front-side flexible substrate 31a is not attached to the front-side probe holding portion 31c, the distal end portion P1 of the probe P protrudes toward the lower side in the z direction from the groove and/or the hole of the probe receptacle 31c1. However, since the spring accommodation portion P2 is held by a step between the upper portion 31c11 of the hole and the lower portion 31c12 of the hole of the probe receptacle 31c1, the probe P does not fall from the probe receptacle 31c1.

When each of the probes P constituting the front-side probe group 31g is placed on the probe receptacle 31c1 of the front-side probe holding portion 31c in a state where the front-side flexible substrate 31a is attached to the front-side probe holding portion 31c, the distal end portion P1 of the probe P comes into contact with a back side of the region where the tongue pieces 31a4 of the front-side flexible substrate 31a are present. For example, among the plurality of probes P, a first probe P is in a positional relation of being in contact with one of regions (one of tongue pieces 31a4) of the front-side flexible substrate 31a electrically connected to the inspection target connector 100. In addition, among the plurality of probes P, a second probe P different from the first probe P is in a positional relation of being in contact with one of the regions (one of tongue pieces 31a4) of the front-side flexible substrate 31a electrically connected to the inspection target connector 100, that is, a tongue piece 31a4 different from the tongue piece 31a4 corresponding to the first probe P. However, since the probe P is light, the probe P is only in contact with the tongue piece 31a4, and is less likely to displace the tongue piece 31a4 to the lower side in the z direction.

Attachment of the assembly of the front-side flexible substrate 31a and the front-side connector 31b to the assembly of the front-side probe holding portion 31c and the front-side connector base 31d is performed in a state where each of the probes P constituting the front-side probe group 31g is placed on the probe receptacle 31c1.

### (Front-side Spring 31h and Front-side Push Block 31i)

The front-side push block 31i is fixed to the upper-side holding portion 23 (upper right holding member 23a and upper left holding member 23b). Fixing of the front-side push block 31i to the upper-side holding portion 23 is performed by screwing from the upper side in the z direction. Therefore, the front-side push block 31i is attached to a bracket 45 via the support portion 43 in a state where a distance in the z direction from the bracket 45 does not vary.

The front-side push block 31i is held by the front-side probe holding portion 31c and the front-side connector base 31d in a state of being movable in the z direction. Holding of the front-side push block 31i in a state of being movable in the z direction by the front-side probe holding portion 31c of the front-side push block 31i is performed by screwing from the rear side in the x direction. The front-side push block 31i is used to press down each of the probes P constituting the front-side probe group 31g toward the lower side in the z direction. That is, the plurality of probes P constituting the front-side probe group 31g are provided between the front-side flexible substrate 31a and the front-side push block 31i.

The front-side spring 31h is provided between the front-side probe holding portion 31c and the front-side push block 31i. The front-side spring 31h biases the front-side push block 31i and the front-side probe holding portion 31c to be separated from each other in the z direction. Therefore, the front-side push block 31i and the front-side probe holding portion 31c are maintained in a separated state by the front-side spring 31h. A spring force of the front-side spring 31h is set to a weight at which the lower-side holding portion (workpiece guide) 21 is fitted without applying an excessive force to the inspection target connector 100 and the probe (extendable member) P is not pressed.

### (Rear-side Substrate Assembly 32)

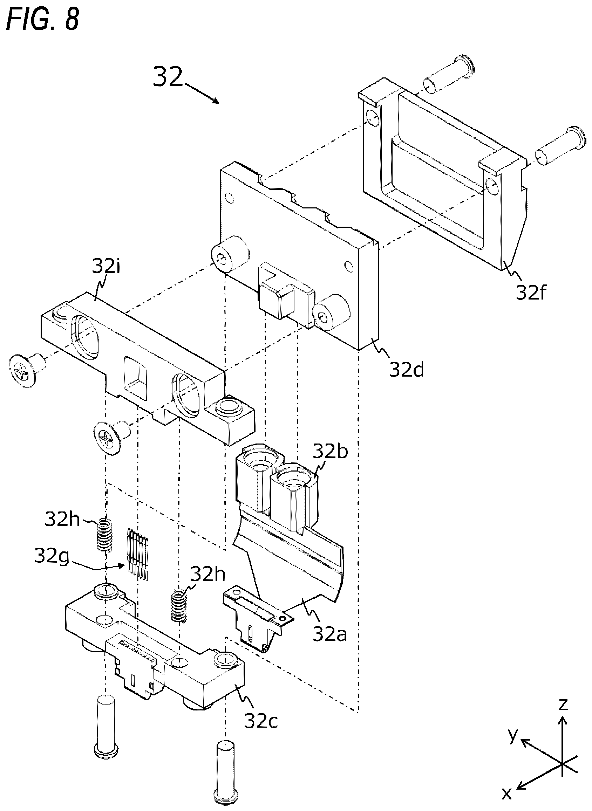

As illustrated in FIG. 8, the rear-side substrate assembly 32 includes the rear-side flexible substrate (flexible substrate) 32a, a rear-side connector 32b, the rear-side probe holding portion 32c, a rear-side connector base 32d, a rear-side connector cover 32f, a rear-side probe group 32g, a rear-side spring 32h, and the rear-side push block (movable member) 32i.

A configuration of the rear-side substrate assembly 32 is the same as a configuration of the front-side substrate assembly 31 except that an orientation of the x direction is reversed. The rear-side flexible substrate 32a of the rear-side substrate assembly 32 corresponds to the front-side flexible substrate 31a of the front-side substrate assembly 31. The rear-side connector 32b of the rear-side substrate assembly 32 corresponds to the front-side connector 31b of the front-side substrate assembly 31. The rear-side probe holding portion 32c of the rear-side substrate assembly 32 corresponds to the front-side probe holding portion 31c of the front-side substrate assembly 31. The rear-side connector base 32d of the rear-side substrate assembly 32 corresponds to the front-side connector base 31d of the front-side substrate assembly 31. The rear-side connector cover 32f of the rear-side substrate assembly 32 corresponds to the front-side connector cover 31f of the front-side substrate assembly 31. The rear-side probe group 32g of the rear-side substrate assembly 32 corresponds to the front-side probe group 31g of the front-side substrate assembly 31. The rear-side spring 32h of the rear-side substrate assembly 32 corresponds to the front-side spring 31h of the front-side substrate assembly 31. The rear-side push block 32i of the rear-side substrate assembly 32 corresponds to the front-side push block 31i of the front-side substrate assembly 31. The number of the front-side connector 31b and the number of the rear-side connector 32b are different in the present embodiment, but the number of the front-side connector 31b and the number of the rear-side connector 32b may be the same.

### (Horizontal Position Adjusting Portion 40)

The horizontal position adjusting portion 40 includes the support portion (movable head) 43 and the bracket 45 (see FIGS. 1 to 4).

### (Support Portion 43)

The support portion 43 includes the right support member 43a and the left support member 43b. The right support member 43a and the left support member 43b are arranged in the y direction. Each of the right support member 43a and the left support member 43b has an elastic member such as an annular coil spring (not illustrated) built therein.

The right support member 43a is attached to a lower side of the upper right holding member 23a in the z direction. Attachment of the right support member 43a to the upper right holding member 23a is performed by screwing from the upper side in the z direction. In addition, the right support member 43a is attached to a lower side of the bracket 45 in the z-direction. The right support member 43a and the bracket 45 sandwich the upper right holding member 23a in the z direction. Attachment of the right support member 43a to the bracket 45 is performed by screwing from the upper side in the z direction through a hole of the upper right holding member 23a.

A region of the right support member 43a attached to the upper right holding member 23a is relatively movable in the xy directions (directions perpendicular to z direction) with respect to the region of the right support member 43a attached to the bracket 45 via the elastic member of the right support member 43a. Therefore, the upper right holding member 23a is held between the right support member 43a and the bracket 45 in a state of being movable in the xy directions.

The left support member 43b is attached to a lower side of the upper left holding member 23b in the z direction. Attachment of the left support member 43b to the upper left holding member 23b is performed by screwing from the upper side in the z direction. In addition, the left support member 43b is attached to the lower side of the bracket 45 in the z-direction. The left support member 43b and the bracket 45 sandwich the upper left holding member 23b in the z direction. Attachment of the left support member 43b to the bracket 45 is performed by screwing from the upper side in the z direction through a hole of the upper left holding member 23b.

A region of the left support member 43b attached to the upper left holding member 23b is relatively movable in the xy directions with respect to the region of the left support member 43b attached to the bracket 45 via the elastic member of the left support member 43b. Therefore, the upper left holding member 23b is held between the left support member 43b and the bracket 45 in a state of being movable in the xy directions.

The support portion 43 (right support member 43a and left support member 43b) is used to absorb a deviation from a position facing the electrodes of the inspection target connector 100 in the z direction regarding a region where the tongue pieces 31a4 of the front-side flexible substrate 31a of the front-side substrate assembly 31 are present and a region where tongue pieces of the rear-side flexible substrate 32a of the rear-side substrate assembly 32 are present.

For example, it is assumed that the region where the tongue pieces 31a4 of the front-side flexible substrate 31a of the front-side substrate assembly 31 are present and the region where the tongue pieces of the rear-side flexible substrate 32a of the rear-side substrate assembly 32 are present are deviated on an xy plane from the position facing the electrodes of the inspection target connector 100 in the z direction. In this case, when the inspection jig 1 is attached to the inspection target connector 100, the bracket 45, the region of the right support member 43a attached to the bracket 45, and the region of the left support member 43b attached to the bracket 45 do not move, and the substrate holding portion 20, the substrate portion 30, the region of the right support member 43a attached to the upper right holding member 23a, and the region of the left support member 43b attached to the upper left holding member 23b can move on the xy plane.

### (Bracket 45)

The bracket 45 is attached to a device (not illustrated) that holds and moves the inspection jig 1, such as an inspection device or a machine tool. The bracket 45 holds the front-side push block 31i and the rear-side push block 32i via the support portion 43 and the upper-side holding portion 23 in a state of being movable in a direction perpendicular to the z-direction.

The bracket 45 includes a first region 45a, a second region 45b, and a third region 45c. The first region 45a is positioned at a right end portion of the bracket 45, the second region 45b is positioned at a left end portion of the bracket 45, and the third region 45c is positioned between the first region 45a and the second region 45b. The upper right holding member 23a and the right support member 43a are disposed on a lower side of the first region 45a in the z direction. The upper left holding member 23b and the left support member 43b are disposed on a lower side of the second region 45b in the z direction.

The third region 45c has a cutout for accommodating the front-side connector 31b of the front-side substrate assembly 31 and the rear-side connector 32b of the rear-side substrate assembly 32. The third region 45c is sandwiched in the x direction between the front-side connector 31b of the front-side substrate assembly 31 and the rear-side connector 32b of the rear-side substrate assembly 32. Accordingly, upper ends of the front-side connector 31b and the rear-side connector 32b are positioned on an upper side of the upper-side holding portion 23 and the support portion 43 in the z direction.

### (Positional Relation between Front-side Push Block 31i and the like and Support Portion 43)

The front-side push block 31i and the rear-side push block 32i are disposed at positions closer to the bracket 45 than the support portion 43.

### (Material for Each Portion, Metal Component, and Resin Component)

Among members constituting the inspection jig 1, the front-side probe group 31g, the rear-side probe group 32g, screws, and conductive regions such as the front-side flexible substrate 31a are made of metal. Other members constituting the inspection jig 1 are made of a non-conductive member such as a resin.

### (Procedure of Connecting Inspection Jig 1 to Inspection Target Connector 100)

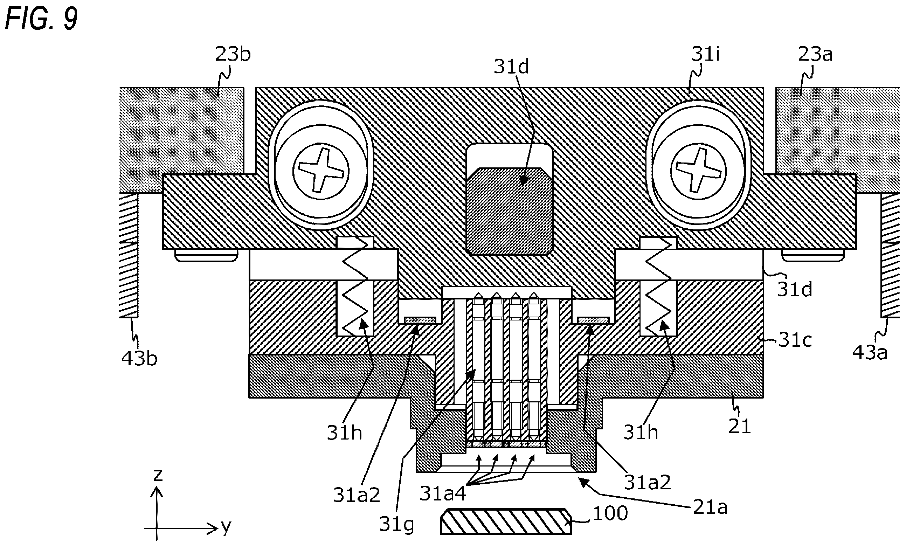

Next, a change in an extension and contraction state of the front-side spring 31h and the like when the inspection jig 1 is moved from the upper side in the z direction to the lower side in the z direction to be connected to the inspection target connector 100 will be described (FIGS. 9 to 14).

In yz cross-sectional configuration views of FIGS. 9 and 11 to 13, the probes P are illustrated larger than those illustrated in other drawings such as FIG. 1 in order to facilitate understanding of the configuration of a region where the probes P are present. Therefore, the number of the probes P, an aspect ratio of each member, and the like do not match between the yz cross-sectional configuration views of FIGS. 9 and 11 to 13 and the other drawings such as FIG. 1.

The rear-side spring 32h is not illustrated in the yz cross-sectional configuration views of FIGS. 9 and 11 to 13. However, the rear-side spring 32h is positioned on a rear side of the front-side spring 31h in the x direction, and extends and contracts in the same manner as the front-side spring 31h. The rear-side push block 32i is not illustrated in the yz cross-sectional configuration views of FIGS. 9 and 11 to 13. However, the rear-side push block 32i is positioned on the rear side of the front-side push block 31i in the x direction, and moves in the same manner as the front-side push block 31i. In addition, the rear-side probe group 32g is not illustrated in the yz cross-sectional configuration views of FIGS. 9 and 11 to 13. However, the rear-side probe group 32g is positioned on the rear side of the front-side probe group 31g in the x direction, and operates in the same manner as the front-side probe group 31g. In addition, the tongue piece of the rear-side flexible substrate 32a is not illustrated. However, the tongue piece of the rear-side flexible substrate 32a is positioned on the rear side of the tongue piece 31a4 of the front-side flexible substrate 31a in the x direction, and is displaced in the same manner as the tongue piece 31a4 of the front-side flexible substrate 31a.

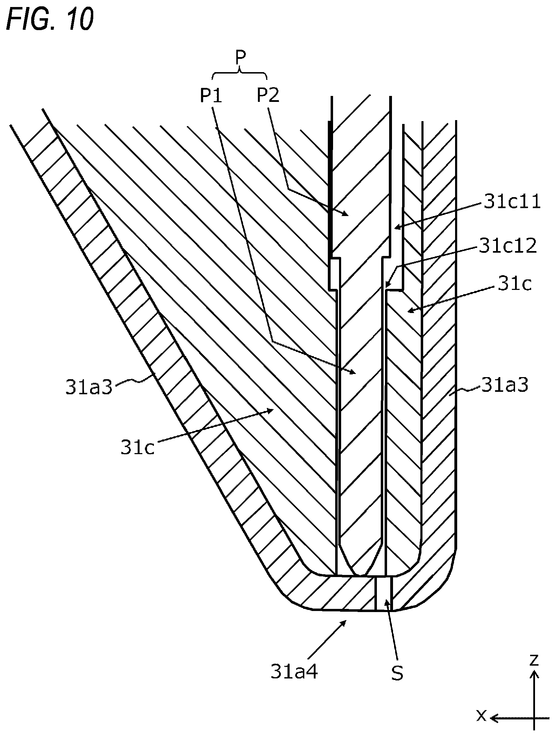

As illustrated in FIG. 9, before the inspection jig 1 is brought into contact with the inspection target connector 100, the front-side spring 31h and the rear-side spring 32h are in an extended state, and both a distance between the front-side push block 31i and the front-side probe holding portion 31c and a distance between the rear-side push block 32i and the rear-side probe holding portion 32c are not short (first state). In this case, the distal end portion P1 on a lower side of the probe P constituting the front-side probe group 31g in the z direction is in contact with the tongue piece 31a4 of the front-side flexible substrate 31a (see FIG. 10). However, since the probe P is light, the tongue piece 31a4 of the front-side flexible substrate 31a is less likely to be pressed down to the lower side in the z direction. Similarly, the distal end portion P1 on the lower side of the probe P constituting the rear-side probe group 32g in the z direction is in contact with the tongue piece of the rear-side flexible substrate 32a. However, since the probe P is light, the tongue piece of the rear-side flexible substrate 32a is less likely to be pressed down to the lower side in the z direction.

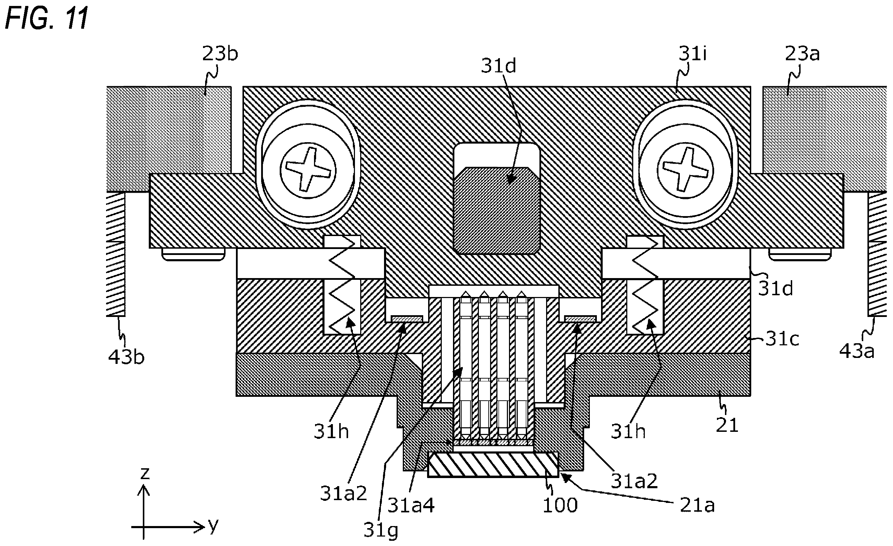

As illustrated in FIG. 11, immediately after the inspection target connector 100 is fitted into the connector contact portion 21a of the inspection jig 1, the front-side spring 31h and the rear-side spring 32h are in an extended state, and both the distance between the front-side push block 31i and the front-side probe holding portion 31c and the distance between the rear-side push block 32i and the rear-side probe holding portion 32c are not short (second state). In this case, the tongue piece 31a4 of the front-side flexible substrate 31a and the tongue piece of the rear-side flexible substrate 32a are not in contact with the inspection target connector 100.

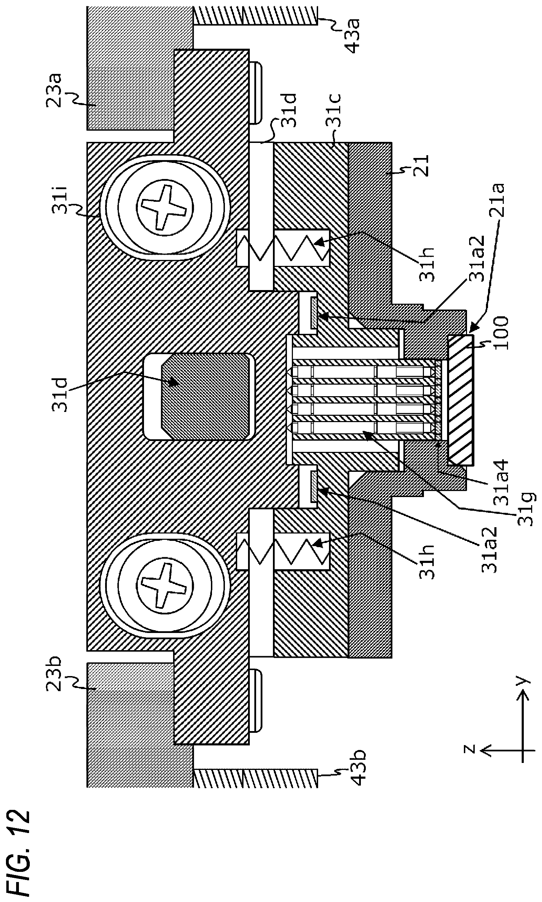

As illustrated in FIG. 12, when the inspection jig 1 further moves to the lower side in the z direction from the second state, the front-side spring 31h contracts in the z direction, and the front-side push block 31i is brought close to the front-side probe holding portion 31c (third state). In this case, the front-side push block 31i is in contact with the upper end portion of the probe P of the front-side probe group 31g. Similarly, the rear-side spring 32h contracts in the z direction, and the rear-side push block 32i is brought close to the rear-side probe holding portion 32c. In this case, the rear-side push block 32i is in contact with the upper end portion of the probe P of the rear-side probe group 32g. However, since the front-side probe group 31g and the rear-side probe group 32g do not press down the tongue piece 31a4 of the front-side flexible substrate 31a and the tongue piece of the rear-side flexible substrate 32a, the front-side probe group 31g and the rear-side probe group 32g are not in contact with the inspection target connector 100.

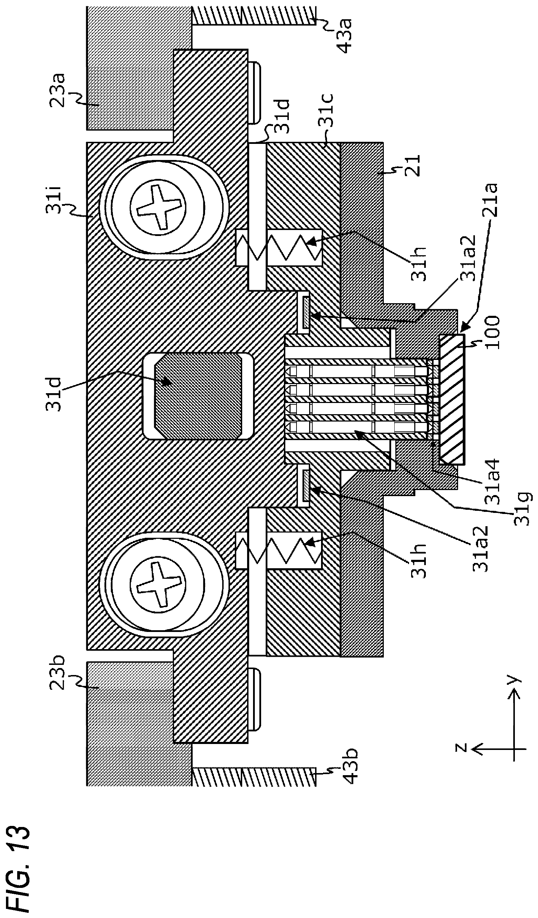

As illustrated in FIG. 13, when the inspection jig 1 further moves to the lower side in the z direction from the third state, the front-side spring 31h further contracts in the z direction, and the front-side push block 31i is further brought close to the front-side probe holding portion 31c (fourth state). In this case, the probe P of the front-side probe group 31g is pressed down by the front-side push block 31i. Similarly, the rear-side push block 32i further contracts in the z direction, and the rear-side push block 32i is brought close to the rear-side probe holding portion 32c. In this case, the probe P of the rear-side probe group 32g is pressed down by the rear-side push block 32i.

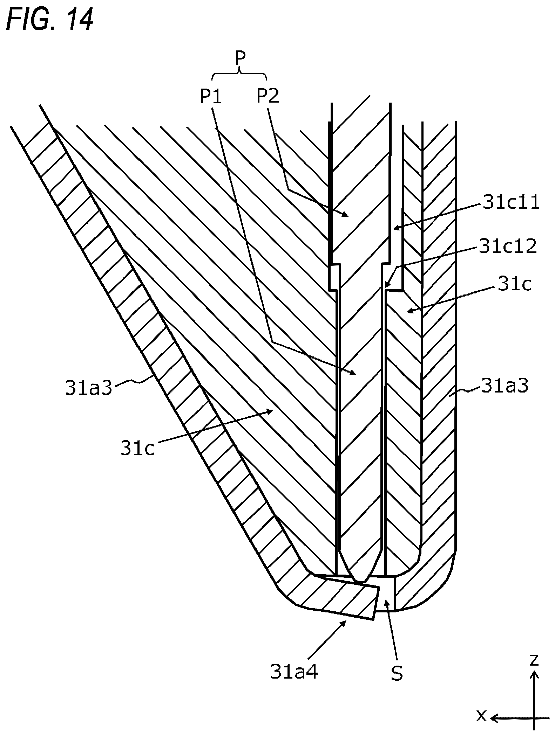

When the front-side push block 31i moves to the lower side in the z direction, the probe P of the front-side probe group 31g moves to the lower side in the z direction, and the distal end portion P1 of the probe P presses the back side (upper side in z direction) of the front-side flexible substrate 31a. As a result, the tongue piece 31a4 of the front-side flexible substrate 31a is pressed down to the lower side in the z direction (see FIG. 14). That is, the tongue piece 31a4 of the front-side flexible substrate 31a is brought close to the electrode of the inspection target connector 100 by the probe P of the front-side probe group 31g. Similarly, when the rear-side push block 32i moves to the lower side in the z direction, the probe P of the rear-side probe group 32g moves to the lower side in the z direction, and the distal end portion P1 of the probe P presses the back side (upper side in z direction) of the rear-side flexible substrate 32a. As a result, the tongue piece of the rear-side flexible substrate 32a is pressed down to the lower side in the z direction. That is, the tongue piece of the rear-side flexible substrate 32a is brought close to the electrode of the inspection target connector 100 by the probe P of the rear-side probe group 32g.

Accordingly, when the front-side push block 31i is brought close to the front-side probe holding portion 31c such that the front-side spring 31h contracts by a predetermined amount or more, the front-side push block 31i presses the probe P of the front-side probe group 31g, the probe P of the front-side probe group 31g presses the tongue piece 31a4 of the front-side flexible substrate 31a, and the front-side flexible substrate 31a is electrically connected to the inspection target connector 100. Similarly, when the rear-side push block 32i is brought close to the rear-side probe holding portion 32c such that the rear-side spring 32h contracts by a predetermined amount or more, the rear-side push block 32i presses the probe P of the rear-side probe group 32g, the probe P of the rear-side probe group 32g presses the tongue piece of the rear-side flexible substrate 32a, and the rear-side flexible substrate 32a is electrically connected to the inspection target connector 100.

As a result, the front-side flexible substrate 31a and the rear-side flexible substrate 32a are in a state of being electrically connected to the inspection target connector 100. In addition, the front-side push block 31i and the rear-side push block 32i are pressed down to the lowermost end of a movable range in the z direction.

### (Effect of Using Movable Member (Front-side Push Block 31i and the like) and Extendable Member (Probe P) in Inspection Jig 1)

First, the front-side push block 31i presses the probe P of the front-side probe group 31g, and the rear-side push block 32i presses the probe P of the rear-side probe group 32g. The pressed probes P press the tongue piece 31a4 of the front-side flexible substrate 31a and the tongue piece of the rear-side flexible substrate 32a, and bring the front-side flexible substrate 31a and the rear-side flexible substrate 32a into connect with the inspection target connector 100. Therefore, the front-side flexible substrate 31a and the rear-side flexible substrate 32a included in the inspection jig 1 can be electrically connected to the inspection target connector 100 without largely deforming or displacing the front-side flexible substrate 31a and the rear-side flexible substrate 32a. That is, the front-side flexible substrate 31a and the rear-side flexible substrate 32a included in the inspection jig 1 can be electrically connected to the inspection target connector 100 in a state where the inspection jig 1 including the front-side flexible substrate 31a and the rear-side flexible substrate 32a is not easily damaged.

### (Effect of Disposing Movable Member (Front-side Push Block 31i and the like) at Position Closer to Bracket 45 than Support Portion 43)

Regions of at least a part of each of the right support member 43a, the movable member (front-side push block 31i and rear-side push block 32i), and the left support member 43b can be arranged in a direction (y direction) perpendicular to the first direction. Specifically, the regions of at least a part of each of the right support member 43a, the front-side push block 31i, and the left support member 43b overlap when viewed from the y direction. In addition, the regions of at least a part of each of the right support member 43a, the rear-side push block 32i, and the left support member 43b overlap when viewed from the y direction. Therefore, the members can be efficiently disposed, and a dimension of the inspection jig 1 in the z direction can be reduced. By reducing the dimension of the inspection jig 1 in the z direction, it is possible to reduce a load when deviations in the xy directions are adjusted using the support portion 43.

### (Effect of Providing Cutout in Third Region 45c of Bracket 45)

An upper end portion (front-side connector 31b and the like) of the front-side substrate assembly 31 and an upper end portion (rear-side connector 32b and the like) of the rear-side substrate assembly 32 can be accommodated in the cutout, and the dimension of the inspection jig 1 in the z direction can be reduced.

### (Effect of not Changing Distance in z Direction between Front-side Push Block 31i and the like and Bracket 45)

Except for movements in the xy directions caused by the support portion 43, the front-side push block 31i and the rear-side push block 32i are fixed to the bracket 45 in a desired posture. Accordingly, even when the inspection jig 1 and the inspection target connector 100 are attached in an inclined state, it is possible to prevent the inspection jig 1 or the inspection target connector 100 from being damaged.

### (Effect of not Changing Distance in z Direction between Front-side Probe Holding Portion 31c and Region in contact with Housing of Inspection Target Connector 100)

The front-side probe holding portion 31c and the rear-side probe holding portion 32c are fixed to the lower-side holding portion 21 in a desired posture. Accordingly, even when the inspection jig 1 and the inspection target connector 100 are attached in an inclined state, it is possible to prevent the inspection jig 1 or the inspection target connector 100 from being damaged.

### (Effect of Individually Performing Pressing with Probe P)

In consideration of variations in height of portions (electrodes) of the signal line or the ground line that are brought into contact with the inspection target connector 100, it is possible to reliably connect the respective electrodes to the inspection target connector 100 by individually pressing an extendable member such as the probe P against each electrode.

### (Effect of Providing Tongue Piece on Front-side Flexible Substrate 31a and Rear-side Flexible Substrate 32a)

In order to absorb the variations in height of the electrodes, when the extendable member such as the probe P is pressed and a force is partially applied, the tongue piece 31a4 of the front-side flexible substrate 31a formed in a region including a portion to which the force is applied is separated from another region adjacent to the tongue piece 31a4 of the front-side flexible substrate 31a via the slit S, and is displaced in the pressed direction (lower side in z direction). In addition, the tongue piece of the rear-side flexible substrate 32a formed in the region including the portion to which the force is applied is separated from another region adjacent to the tongue piece of the rear-side flexible substrate 32a via the slit S, and is displaced in the pressed direction (lower side in z direction). Therefore, as compared with a case where the tongue piece is not provided, the flexible substrates (front-side flexible substrate 31a and rear-side flexible substrate 32a) are less likely to be damaged even when displaced.

### (Effect of Using End Portion as Electrode)

When electrical connection with another member is performed in the middle of the signal line, a portion between the connection portion and the end portion may function as an antenna to perform reception and transmission of noise. By performing electrical connection with another member in the vicinity of the end portion, it is possible to reduce the reception and transmission of noise. When electrical connection with another member is performed in the middle of the ground line, impedance matching may collapse.

### (Other Embodiments: Extendable Members other than Probe)

In the present embodiment, a mode is described in which the probe P is used as an extendable member that presses the front-side flexible substrate 31a from the back side (upper side in z direction) to the lower side in the z direction and an extendable member that presses the rear-side flexible substrate 32a from the back side (upper side in z direction) to the lower side in the z direction. However, the extendable member is not limited to the probe P, and other elastic members such as a rubber may be used as long as the member is extendable in the z direction.

### (Other Embodiments: Elastic Members other than Spring)

In the description of the present embodiment, the front-side spring 31h is provided between the front-side probe holding portion 31c and the front-side push block 31i, and the rear-side spring 32h is provided between the rear-side probe holding portion 32c and the rear-side push block 32i. However, the extendable member is not limited to the spring, and other elastic members may be used as long as the member is extendable in the z direction.

### [Other Embodiments: Substrate]

In the description of the present embodiment, the substrate incorporated in the inspection jig 1 is a substrate having flexibility. However, the substrate incorporated in the inspection jig 1 may be a substrate having no flexibility.

While certain embodiments of the present invention are described, these embodiments are presented by way of example only, and are not intended to limit the scope of the present invention. These embodiments can be implemented in various other forms, and various omissions, replacements, and modifications can be made without departing from the gist of the invention. These embodiments and modifications thereof are included in the scope of the invention or the gist of the invention, and are included in a scope equivalent to the invention described in the claims.

According to the present description, an inspection jig according to the following aspects is provided.

### (Aspect 1)

An aspect 1 including: a substrate that is electrically connectable to an inspection target connector; a movable member that is movable; an extendable member that is extendable; an extendable member holding portion that holds the extendable member; and an elastic member that biases the movable member and the extendable member holding portion to be separated from each other. In the aspect 1, when the movable member is brought close to the extendable member holding portion such that the elastic member contracts by a predetermined amount or more, the movable member presses the extendable member, the extendable member presses the substrate, and the substrate is electrically connected to the inspection target connector.

According to the above aspect, the movable member first presses the extendable member. The pressed extendable member presses the substrate to bring the substrate into electrical connection with the inspection target connector. Therefore, it is possible to bring the substrate included in the inspection jig into electrical connection with the inspection target connector without greatly deforming or displacing the substrate. That is, it is possible to bring the substrate included in the inspection jig into electrical connection with the inspection target connector in a state where the inspection jig including the substrate is less likely to be damaged.

### (Aspect 2)

An aspect 2 further including: a support portion; and a bracket that holds the movable member in a state of being movable in a direction perpendicular to a first direction via the support portion. In the aspect 2, the movable member is disposed at a position closer to the bracket than the support portion.

According to the above aspect, the members can be efficiently disposed, and a dimension of the inspection jig in the first direction can be reduced. By reducing the dimension of the inspection jig in the first direction, it is possible to reduce a load when a deviation in a direction perpendicular to the first direction is adjusted using the support portion.

### (Aspect 3)

In an aspect 3, the substrate further includes a connector used for electrical connection to an inspection device, and the bracket has a cutout for accommodating the connector.

According to the above aspect, the dimension of the inspection jig in the first direction can be reduced.

### (Aspect 4)

In an aspect 4, the movable member is attached to the bracket via the support portion in a state where a distance in the first direction from the bracket does not vary.

According to the above aspect, the movable member is fixed to the bracket in a desired posture except for the movement of the support portion in the direction perpendicular to the first direction. Accordingly, even when the inspection jig and the inspection target connector are attached in an inclined state, it is possible to prevent the inspection jig or the inspection target connector from being damaged.

### (Aspect 5)

An aspect 5 further including a member that is brought into contact with a housing of the inspection target connector. In the aspect 5, the extendable member holding portion is attached to the member in a state where a distance in the first direction from a region of the member that is in contact with the housing does not vary.

According to the above aspect, the extendable member holding portion is fixed to the member that is brought into contact with the housing of the inspection target connector in a desired posture. Accordingly, even when the inspection jig and the inspection target connector are attached in an inclined state, it is possible to prevent the inspection jig or the inspection target connector from being damaged.

### REFERENCE SIGNS LIST

1: inspection jig
21: lower-side holding portion (workpiece guide, member that is brought into contact with housing of inspection target connector)
31a: front-side flexible substrate (flexible substrate)
31b: front-side connector
31c: front-side probe holding portion (extendable member holding portion)
31h: front-side spring (elastic member)
31i: front-side push block (movable member)
32a: rear-side flexible substrate (flexible substrate)
32b: rear-side connector
32c: rear-side probe holding portion (extendable member holding portion)
32h: rear-side spring (elastic member)
32i: rear-side push block (movable member)
43: support portion
45: bracket
100: inspection target connector
P: probe (extendable member)

## Claims

1. An inspection jig comprising:
a substrate that is electrically connectable to an inspection target connector;
a movable member that is movable;
an extendable member that is extendable;
an extendable member holding portion that holds the extendable member; and
an elastic member that biases the movable member and the extendable member holding portion to be separated from each other, wherein
when the movable member is brought close to the extendable member holding portion such that the elastic member contracts by a predetermined amount or more, the movable member presses the extendable member, the extendable member presses the substrate, and the substrate is electrically connected to the inspection target connector.

2. The inspection jig according to claim 1, further comprising:
a support portion; and
a bracket that holds the movable member in a state of being movable in a direction perpendicular to a first direction via the support portion, wherein
the movable member is disposed at a position closer to the bracket than the support portion.

3. The inspection jig according to claim 2, wherein
the substrate further includes a connector used for electrical connection to an inspection device, and
the bracket has a cutout for accommodating the connector.

4. The inspection jig according to claim 2 or 3, wherein
the movable member is attached to the bracket via the support portion in a state where a distance in the first direction from the bracket does not vary.

5. The inspection jig according to claim 4, further comprising
a member that is brought into contact with a housing of the inspection target connector, wherein
the extendable member holding portion is attached to the member in a state where a distance in the first direction from a region of the member that is in contact with the housing does not vary.
